Europäisches Patentamt

**European Patent Office**

**Office européen des brevets**

(11) Publication number: **0 133 642
B1**

## (12) EUROPEAN PATENT SPECIFICATION

(45) Date of publication of patent specification: **17.08.88**

(51) Int. Cl.⁴: **H 01 L 27/06,** H 01 L 29/78

(21) Application number: **84107327.3**

(22) Date of filing: **26.06.84**

(54) Semiconductor device comprising a DMOSFET.

(73) Proprietor: **KABUSHIKI KAISHA TOSHIBA
72, Horikawa-cho Saiwai-ku
Kawasaki-shi Kanagawa-ken 210 (JP)**

(72) Inventor: **Ohata, Yu c/o Patent Div. K.K.
TOSHIBA
1-1 Shibaura 1-chome
Minato-ku Tokyo 105 (JP)**
Inventor: **Tanabe, Hirohito c/o Patent Div. K.K.
TOSHIBA
1-1 Shibaura 1-chome
Minato-ku Tokyo 105 (JP)**
Inventor: **Suzuki, Kazuaki c/o Patent Div. K.K.
TOSHIBA
1-1 Shibaura 1-chome
Minato-ku Tokyo 105 (JP)**
Inventor: **Miwa, Yukiharu c/o Patent Div. K.K.
TOSHIBA
1-1 Shibaura 1-chome
Minato-ku Tokyo 105 (JP)**
Inventor: **Nakayama, Yoshihito c/o Patent Div.
K.K. TOSHIBA
1-1 Shibaura 1-chome
Minato-ku Tokyo 105 (JP)**

(74) Representative: **Lehn, Werner, Dipl.-Ing. et al
Hoffmann, Eitle & Partner Patentanwälte
Arabellastrasse 4
D-8000 München 81 (DE)**

(30) Priority: **30.06.83 JP 119355/83**

(43) Date of publication of application:
**06.03.85 Bulletin 85/10**

(45) Publication of the grant of the patent:
**17.08.88 Bulletin 88/33**

(84) Designated Contracting States:
**DE FR GB IT**

(58) References cited:
**EP-A-0 081 269
GB-A-1 342 130
US-A-4 072 975**

Courier Press, Leamington Spa, England.

## Description

The invention relates to semiconductor devices such as power MOSFETs (metal-oxide-semiconductor field effect transistors) used for such purposes as motor control and power control.

The invention specifically relates to a semiconductor device comprising a high impurity concentration semiconductor substrate of a first conductivity type carrying a MOSFET, a low impurity concentration epitaxial layer formed on one surface of said semiconductor substrate, a MOSFET drain electrode formed on the other surface of said semiconductor substrate, first and second MOSFET channel base regions of a second conductivity type formed at a predetermined distance from each other in said low impurity concentration epitaxial layer, first and second high impurity concentration MOSFET source regions of the first conductivity type formed in said resective first and second channel base regions, a MOSFET gate oxide film formed on said low impurity concentration epitaxial layer between said first and second channel base regions, a MOSFET gate electrode formed on said gate oxide film, an insulation film formed on said gate electrode, a MOSFET source electrode formed on said insulation film, channel base regions and source regions, a parasitic diode formed by said first and second channel base regions and said low impurity conentration epitaxial layer, and a junction constituting a diode electrically in parallel with said parasitic diode and having a forward voltage drop lower than that of said parasitic diode.

Such a semiconductor device is e.g. known from EP—A—0 081 269. In this known semiconductor device, the junction constituting a diode is a Schottky junction having a reverse breakdown voltage of about 100 volts or less.

The power MOSFETs of the type noted generally handle large currents and high voltages. They are of various structures, e.g., a double diffusion type MOS (hereinafter referred to as D MOS), a V MOS or a U MOS.

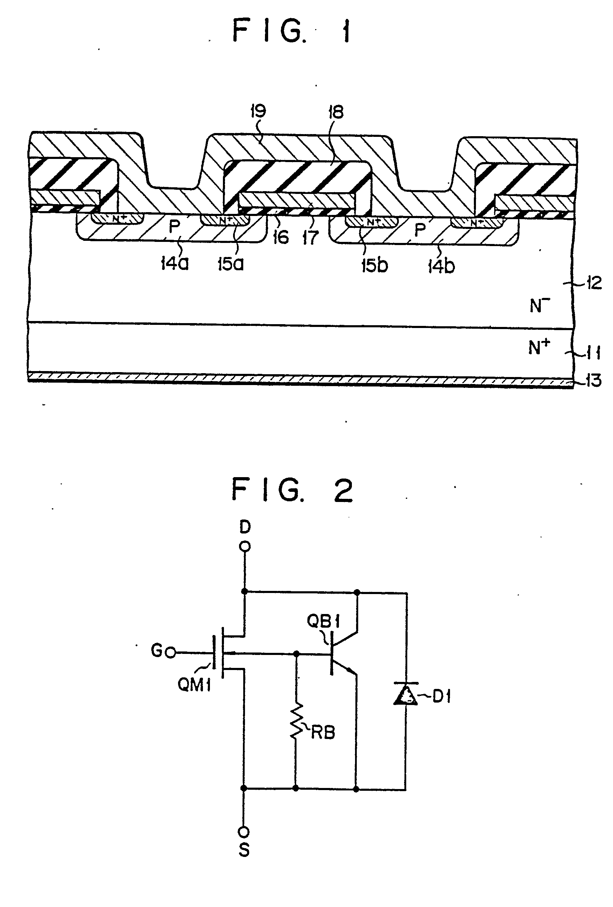

Fig. 1 typically shows the sectional structure of a D MOSFET. It comprises an $N^+$-type high impurity concentration silicon substrate 11, on one surface of which is formed an $N^-$-type low impurity concentration silicon epitaxial layer 12. The high impurity concentration silicon substrate 11 and low impurity concentration silicon epitaxial layer 12 constitute a drain region of a MOSFET. A drain electrode 13 is formed on the other surface of the substrate 11. The low impurity concentration silicon epitaxial layer 12 has P-type impurity diffusion regions 14a and 14b formed at a predetermined distance from each other as a base region of the channel of the MOSFET. $N^+$-type impurity diffusion regions 15a and 15b are formed in the respective regions 14a and 14b as a source region of the MOSFET. A gate insulation film 16 is formed on the low impurity concentration silicon epitaxial layer 12 such that it covers part of the surface of the impurity diffusion regions 14a, 14b, 15a and 15b. A gate electrode layer 17 is formed on the gate insulation film 16. An insulation film 18 is formed on the gate electrode layer 17, and a source electrode layer 19 is formed on the insulation film 18. The source electrode layer 19 is contiguous to part of the impurity diffusion regions 14a and 14b (i.e., channel base regions) and impurity diffusion regions 15a and 15b (i.e., source regions). Fig. 1 shows some D MOSFETs which are formed continuously in a row.

Fig. 2 shows an equivalent circuit of the structure described above. The drain D of MOSFET QM1 is constituted by the high inpurity concentration silicon substrate 11 and low inpurity concentration silicon epitaxial layer 12. The source S of the MOSFET is constituted by the N-type impurity diffusion regions 15a and 15b. The gate electrode G of the MOSFET is constituted by the gate electrode layer 17. A resistor RB is constituted by the resistance of the impurity diffusion regions 14a and 14b. The circuit also comprises an NPN bipolar transistor QB1. The emitter of transistor QB1 is constituted by the $N^+$-type impurity diffusion regions 15a and 15b, the base of the transistor is constituted by the p-type impurity diffusion regions 14a and 14b, and the collector of the transistor is constituted by the $N^-$-type low inpurity concentration silicon epitaxial layer 12. The circuit further comprises a diode D1. The anode of the diode D1 is constituted by the P-type impurity diffusion regions 14a and 14b. The cathode of the diode is constituted by the $N^-$-type silicon epitaxial layer 12. The bipolar transistor QB1 and diode D1 are formed parasitically. The equivalent circuit shown in Fig. 2 applies to other MOSFET structures (i.e., V MOSFETs and U MOSFETs) as well.

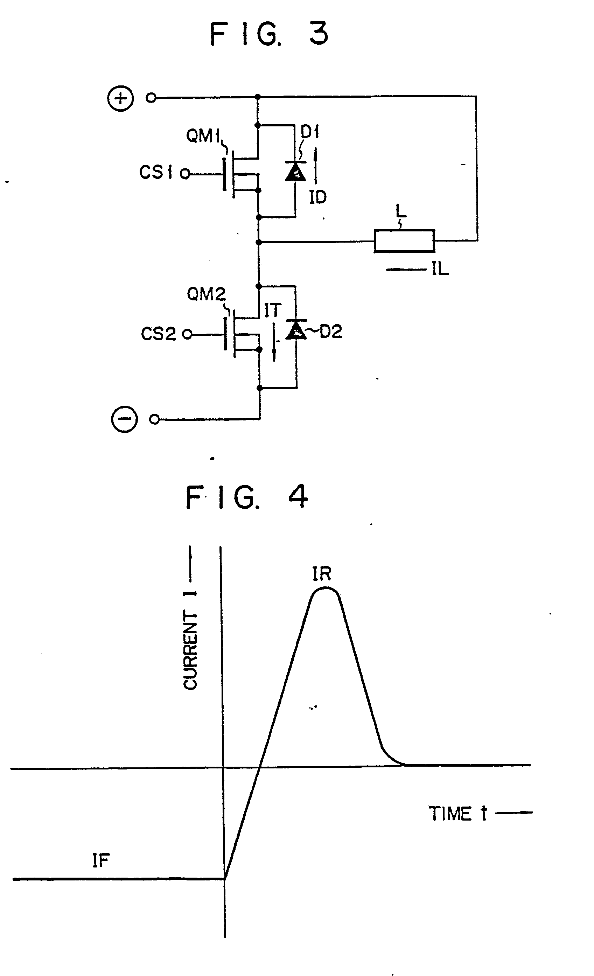

Fig. 3 shows a motor control circuit, in which power MOSFETs are used. The circuit uses two MOSFETs QM1 and QM2 which are serially connected between positive and negative power supply terminals. A winding L of the motor is connected between the point of connection between the MOSFETs QM1 and QM2 and positive power supply terminal. The MOSFETs QM1 and QM2 are selectively on-off controlled according to control signals CS1 and CS2, whereby the winding L is energized. Although not shown, the circuit as described above is provided for each winding of the motor, and the rotation of the motor is controlled according to the state of excitation state of each winding. In this circuit, when the MOSFET QM2 is on while the MOSFET QM1 is off, a current path is formed from the positive power supply terminal path through the winding L and MOSFET QM2 to the negative power supply terminal. Thus, a current IL flows through the winding L, and a current IT flows through the MOSFET QM2. Wnen MOSFET QM2 is off, a freewheel current ID flows through the diode D1. While the diode D1 is carrying the forward current ID, carriers are being stored in the cathode region (i.e., the $N^-$-type silicon epitaxial layer) 12 shown in Fig. 1. At the time of the transition of the MOSFET QM2 from the off state to the on state, the stored carriers are led from the cathode region 12 through the anode region (i.e., through the P-type impurity diffusion regions 14a and 14b) to the source electrode layer 19. This constitutes a reverse recovery current IR as shown in Fig. 4. The current IR causes a voltage drop across the resistance RB of the channel base region (i.e., P-type impurity diffusion regions 14a and 14b) under the impurity diffusion regions 15a and 15b. As a result, the base-emitter path of the parasitic bipolar transistor QB1 is forwardly biased, thus turning on the transistor QB1. When the transistor QB1 is turned on, a current concentration is produced under the N-type impurity diffusion regions 15a and 15b which elevates the temperature of the immediate surrounding and, in the extreme case, which can cause a rupture of the MOSFET.

The object of the invention is to provide a semiconductor device comprising a MOSFET which is inherently less susceptible to rupture and which can operate with improved speed and efficiency.

This object is solved by an impurity diffusion region of the second conductivity type formed in said low impurity concentration epitaxial layer to constitute said diode electrically in parallel with said parasitic diode, the source electrode being formed on the second conductivity type impurity diffusion region constituting said diode, and by the bypass diode having said forward voltage drop lower than that of the parasitic diode whereby forward current otherwise flowing through the parasitic diode is in use branched through the bypass diode, such that carriers stored in the low impurity concentration epitaxial layer are conducted to a location to prevent a parasitic bipolar transistor from operating and to increase the breakdown voltage of the MOSFET.

With this structure, the forward current that flows through the parasitic diode (formed by the junction between the channel base region and drain region of tm MOSFET) is branched through the diode to reduce stored carriers, thus preventing the parasitic bipolar transistor from acting and freeing it from rupture in the freewheel operation. In addition, the reverse recovery time of the diode connected between the source and drain of the MOSFET may be set to be shorter than the reverse recovery time of the parasitic diode, thus reducing the speed of the operation as a freewheel diode and reducing the power loss, i.e., increasing efficiency.

This invention can be more fully understood from the following detailed description when taken in conjunction with the accompanying drawings, in which:

Fig. 1 is a fragmentary enlarged-scale sectional view showing a prior art power MOSFET;

Fig. 2 is a circuit diagram showing an equivalent circuit of the MOSFET shown in Fig. 1;

Fig. 3 is a circuit diagram showing an arrangement, in which the power MOSFET shown in Figs. 1 and 2 is used for a motor control circuit;

Fig. 4 is a graph for explaining the operation of the circuit shown in Fig. 3;

Fig. 5 is a view similar to Fig. 1 but showing an embodiment of the semiconductor device according to the invention;

Fig. 6 is a circuit diagram showing an equivalent circuit of the embodiment shown in Fig. 5; and

Figs. 7 through 11 are views similar to Fig. 5 showing different examples of MOSFET according to the invention.

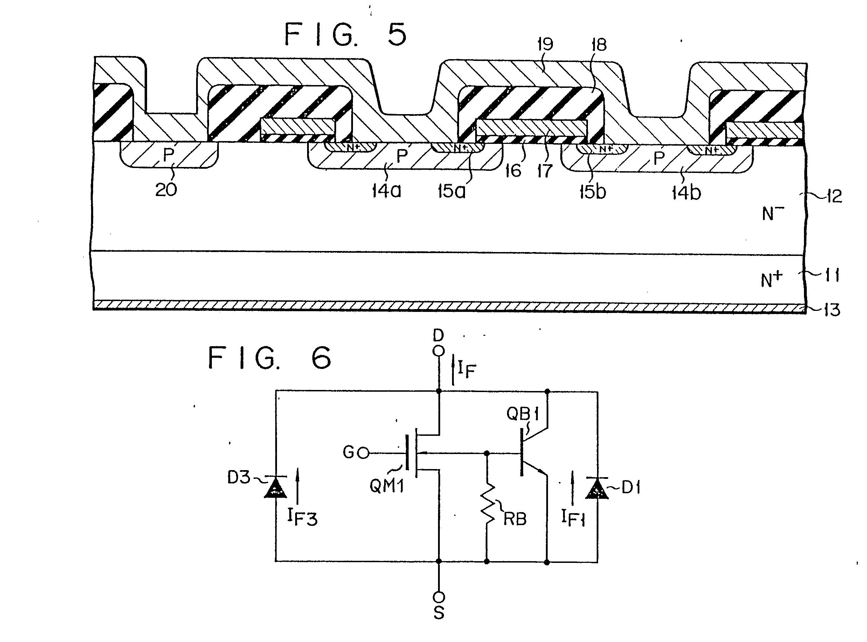

Figs. 5 and 6 are respectively a fragmentary enlarged-scale sectional view and an equivalent circuit diagram of an embodiment of the invention applied to a power MOSFET. In the figures, the same parts as those in Figs. 1 and 2 are designated by like reference numerals. In this instance, a diode D3 has its anode and cathode connected to the source and drain of the MOSFET QM1, respectively. The illustrated power MOSFET comprises an $N^+$-type high impurity concentration silicon substrate 11, on one surface of which is formed an $N^-$-type low impurity concentration silicon epitaxial layer 12. The high impurity concentration silicon substrate 11 and low impurity concentration silicon epitaxial layer 12 constitute a drain region of a MOSFET. A drain electrode 13 is formed on the other surface of the substrate 11. The $N^-$-type low impurity concentration silicon epitaxial layer 12 has P-type impurity diffusion regions 14a and 14b formed at a predetermined distance from each other, which constitute the channel base region of the MOSFET. The p-type impurity diffusion regions 14a and 14b are formed by diffusing a P-type impurity, e.g., boron. The $N^-$-type low impurity concentration silicon epitaxial layer 12 also has a P-type impurity diffusion region 20 according to the invention which is formed at a predetermined distance from the impurity diffusion regions 14a and 14b (via the adjacent MOSFET). The P-type impurity diffusion region 20 serves as an anode region of diode D3. The surface impurity concentration diffusion regions 14a and 14b is set to be about $1 \times 10^{18}$ cm$^{-3}$, for instance The surface impurity concentration diffusion region 20 is set to be about $1 \times 10^{19}$ to $1 \times 10^{20}$ cm$^{-3}$. The impurity diffusion region 20 and silicon epitaxial layer 12 constitute the diode D3. The impurity diffusion regions 14a and 14b have respective $N^+$-type impurity diffusion regions 15a and 15b which serve as a source region of the MOSFET. The $N^+$-type impurity diffusion regions 15a and 15b are formed by diffusing an N-type impurity, e.g., phosphorus or arsenic. A gate insulation film 16 is formed on the low impurity concentration silicon epitaxial layer 12 such that it covers part of the surface of the impurity diffusion regions 14a, 14b, 15a and 15b. A gate electrode layer 17 is formed on the gate insulation layer 16. An inter-electrode insulation film 18 is formed on the interelectrode insulation film 17. A source electrode 19 is formed on the interelectrode insulation film 18. The source electrode 19 is contiguous to part of the impurity diffusion regions 14a and 14b (i.e.,

channel base regions of the MOSFET), impurity diffusion regions 15a and 15b (i.e., source region of the MOSFET) and impurity diffusion region 20 (i.e., anode region of the diode D3).

The forward voltage drop $V_{F3}$ of the diode D3 is set to be lower than the forward voltage drop $V_{F1}$ of the parasitic diode D1 constituted by the P-type impurity diffusion regions 14a and 14b and N-type epitaxial layer 12. The difference between the forward voltage drops $V_{F3}$ and $V_{F1}$ is suitably about 0.4 V when the forward current $I_F$ is 15 A, for instance, and it is determined by the impurity concentrations of the impurity diffusion regions 14a, 14b and 20.

With the structure as described, the forward current $I_F$ is branched between the parasitic diode D1 and diode D3, as shown in the equivalent circuit diagram of Fig. 6; it is the sum of the forward currents $I_{F1}$ and $I_{F3}$ through the respective diodes D1 and D3. In other words, the forward current $I_{F1}$ through the parasitic diode D1 is reduced by the diode D3 when the forward current $I_F$ is fixed. The reverse recovery current $I_{R1}$ due to the parasitic diode D1 is thus reduced to reduce the forward bias voltage on the parasitic bipolar transistor QB1 that appears across the base resistance RB, thus preventing the action of the transistor QB1. In particular, the forward voltage drops $V_{F1}$ and $V_{F3}$ across the respective diodes D1 and D3 are set such that:

$$V_{F1} > V_{F3}$$

to obtain

$$I_{F1} \ll I_{F3}$$

so as to permit a great reduction in the carriers stored in the cathode region of the diode D1 (i.e., in the $N^-$-type silicon epitaxial layer 12). It is thus possible to prevent rupture of the MOSFET element and to greatly improve the reverse breakdown voltage thereof.

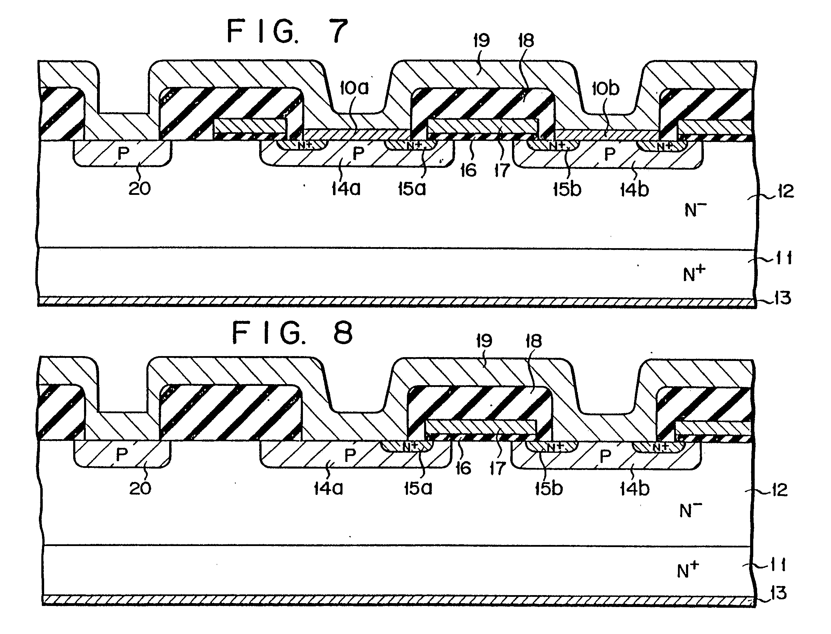

Further, by setting the reverse recovery time trr3 of the diode D3 to be shorter than the reverse recovery time trrl of the parasitic diode D1 while having the relation $V_{F1} > V_{F3}$ between the forward voltage drops $V_{F1}$ and $V_{F3}$ of the diodes D1 and D3, the reverse recovery current $I_R$ and reverse recovery time trr at the time of the freewheel diode operation can be reduced. It is thus possible to realize a great increase in the speed of the switching operation of the MOSFET and to save power, thus increasing efficiency. The forward voltage drops $V_{F1}$ and $V_{F3}$ can be suitably set be appropriately setting the difference between the contact resistance of the impurity diffusion regions 14a and 14b and that of the impurity diffusion region 20, the resistance of these regions depending on the impurity concentration thereof. For example, the forward voltage drop $V_{F1}$ of the diode D1 can be varied by selectively forming barrier layers 10a and 10b of titanium, doped polysilicon, molybdenum silicide, titanium nitride, etc., as shown in Fig. 7. As for setting the reverse recovery times trr1 and trr3, the carrier lifetime in the diode D3 may be solely changed by selectively diffusing a lifetime killer, e.g., platinum or gold, in the impurity diffusion region 20 and by surrounding portions of the low impurity concentration silicon epitaxial layer 12, thereby obtaining the best characteristics (i.e., reverse recovery times trr1 and trr3) of the MOSFET QM1 and diode D3.

Fig. 8 shows a different embodiment of the invention. In this cnstance, the gate electrode layer 17, gate insulation film 16 and impurity diffusion region 15 adjacent to the MOSFET shown in Fig. 5 are partly omitted. In Fig. 8, the same parts as those in Fig. 5 are designated by like reference numerals. Even with this structure, the equivalent circuit is as in Fig. 6, and the same results as discussed above in connection with the preceding examples can be obtained.

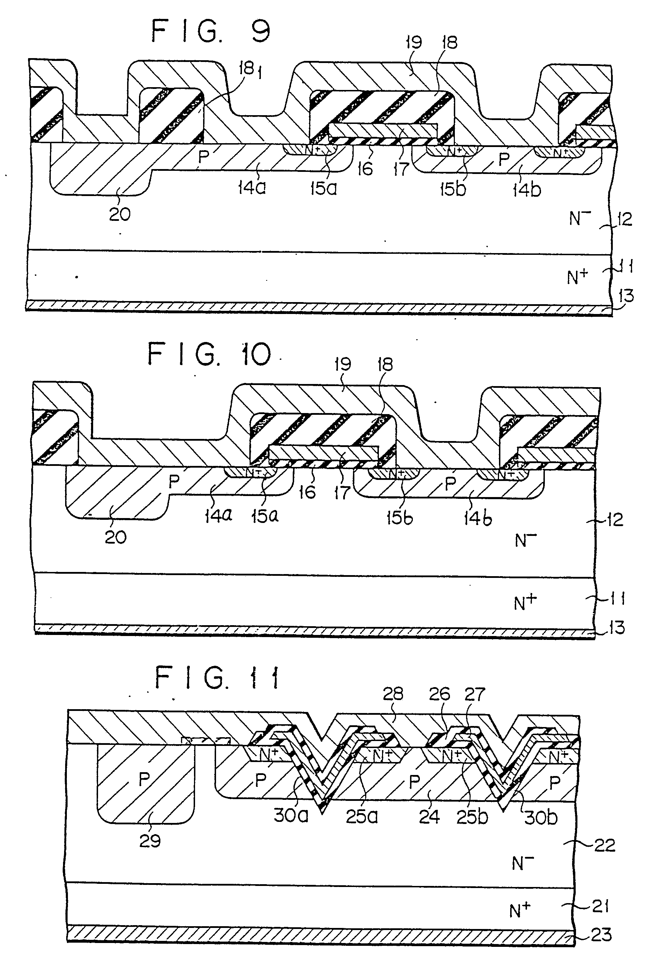

Fig. 9 shows a further emodiment of the invention. While in the above examples the MOSFET QM1 and diode D3 are spaced-apart from each other, in this instance the anode region of diode D3 (i.e., P-type impurity region 20) is formed such that it is continguous to the channel base region of MOSFET QM1 (i.e., P-type impurity diffusion region 14a). On one surface of the $N^+$-type high impurity concentration silicon substate 11 is formed an $N^-$-type low impurity concentration silicon epitaxial layer 12. The high impurity concentration silicon substrate 11 and low impurity concentration silicon epitaxial layer 12 form the drain region of the MOSFET. A drain electrode 13 is formed on the other surface of the high impurity concentration silicon substrate 11. The low impurity concentration silicon epitaxial layer 12 has P-type impurity diffusion regions 14a and 14b formed at a predetermined distance from each other as the channel base region of the MOSFET. The silicon epitaxial layer 12 also has a P-type impurity diffusion region 20 formed contiguous to the impurity diffusion region 14a as the anode of diode D3. The impurity diffusion regions 14a and 14b have respectively N-type impurity diffusion regions 15a and 15b serving as the source region of the MOSFET. A gate insulation film 16 is formed on the low impurity concentration silicon epitaxial layer 12 such that it covers part of the surface of the impurity diffusion regions 14a, 14b, 15a and 15b. A gate electrode layer 17 is formed on the gate insulation film 16. Insulation film 18 is formed on the gate electrode layer 17. Source electrode layer 19 is formed on the insulation film 18. The source electrode layer 19 is contiguous to the impurity diffusion regions 14a and 14b (constituting the channel base region of the MOSFET), impurity diffusion regions 15a and 15b (constituting the source region of the MOSFET) and impurity diffusion region 20 (constituting the anode region of the diode). With this structure again the equivalent circuit is as in Fig. 6, and the same results as in the preceding examples can be obtained.

Further, the insulation film 18 shown in Fig. 9 may be omitted as shown in Fig. 10 to obtain same results.

With the structures shown in Figs. 8 to 10, the forward voltage drps may be set in the manner as described before in connection with the structure shown in Fig. 7. Further, while the above embodiment have concerned MOSFETs of the N-channel type, the invention is of course applicable to the P-type channel MOSFET as well. In this case, the polarity of the diode is reversed. Further, while the D MOSFETs have been described, the same results may also be obtained with MOSFETs of other structures such as a V MOSFET or a U MOSFET so long as a diode of the same polarity as the parasitic diode is connected in parallel between the source and drain of the MOSFET.

Fig. 11 shows a further embodiment of the invention applied to a V MOSFET. On one surface of an $N^+$-type high impurity concentration silicon substrate 21 is formed an $N^-$-type low impurity concentration silicon epitaxial layer 22. A drain electrode 23 is formed on the other substrate surface. The low impurity concentration silicon epitaxial layer 22 has a P-type impurity diffusion region 24 and another P-type impurity diffusion region 29 formed at a predetermined distance form the region 24 and serving as an anode region of the diode. The impurity diffusion region 24 has $N^+$-type impurity diffusion regions 25a and 25b. V-shaped grooves 30a and 30b are formed as shown in the impurity diffusion regions 25a and 25b and 24 by anisotropic etching. Gate electrodes 27 consisting of polysilicon are formed in the grooves 30a and 30b via a silicon oxide film 26. A source electrode 28 of aluminum is formed over the gate electrodes 27 via a silicon oxide film 26. The source electrode 28 extends to cover the P-type impurity diffusion region 29. The P-type impurity diffusion region 29 and $N^-$-type low impurity concentration epitaxial layer 22 constitute a diode.

With the above structure, the same results can be obtained as with the D MOSFETs described before. In addition, the structure permits similar modifications. Moreover, the invention is applicable to four-layer elements have MOS structures other than the V MOSFET and U MOSFET.

**Claims**

1. A semiconductor device comprising a high impurity concentration semiconductor substrate (11) of a first conductivity type carrying a MOSFET (QM1), a low impurity concentration epitaxial layer (12) formed on one surface of said semiconductor substrate (11), a MOSFET drain electrode (13) formed on the other surface of said semiconductor substrate (11), first and second MOSFET channel base regions (14a, 14b) of a second conductivity type formed at a predetermined distance from each other in said low impurity concentration epitaxial layer (12), first and second high impurity concentration MOSFET source regions (15a, 15b) of the first conductivity type formed in said respective first and second channel base regions (14a, 14b), a MOSFET gate oxide film (16) formed on said low impurity concentration epitaxial layer (12) said first and second channel base regions (14a, 14b), such that it covers part of the surface of said channel base and source regions a MOSFET gate electrode (17) formed on said gate oxide film (16), an insulation film (18) formed on said gate electrode (17), a MOSFET source electrode (19) formed on said insulation film (18), channel base regions (14a, 14b) and source regions (15a, 15b) a parasitic diode (D1) formed by said first and second channel base regions (14a, 14b) and said low impurity concentration epitaxial layer (12), and a junction constituting a diode (D3) electrically in parallel with said parasitic diode (D1) and having a forward voltage drop lower than that of said parasitic diode (D1), characterized by an impurity diffusion region (20) of the second conductivity type formed in said low impurity concentration epitaxial layer (12) to constitute said diode (D3) electrically in parallel with said parasitic diode (D1), the source electrode (19) being formed on the second conductivity type impurity diffusion region (20) constituting said diode, and by the bypass diode (D3) having said forward voltage drop lower than that of the parasitic diode (D1) whereby forward current otherwise flowing through the parasitic diode (D1) is in use branched through the bypass diode (D3), such that carriers stored in the low impurity concentration epitaxial layer (12) are conducted to a location to prevent a parasitic bipolar transistor (QB1) from operating and to increase the breakdown voltage of the MOSFET (QM1).

2. A semiconductor device according to claim 1, characterized by barrier layers (10a, 10b) formed in contact areas between said first and second channel base regions (14a, 14b) and first and second source regions (15a, 15b) and said source region (19).

3. A semiconductor device according to claim 1 or 2, characterized in that said second conductivity type impurity diffusion region (20) constituting said bypass diode (D3) is formed at a predetermined distance from said first and second channel base regions (14a, 14b).

4. A semiconductor device according to claim 3 characterized in that an insulation film (18) is formed on said low impurity concentration epitaxial layer (12) between said channel base region (14a) and impurity diffusion region (20).

5. A semiconductor device according to claim 3 or 4, characterized by a gate oxide film formed on said low impurity concentration epitaxial layer (12) between a channel base region (14a) and impurity diffusion region (20), a gate electrode formed on said gate oxide film, an insulation film formed on said gate electrode, and a high impurity concentration source region of the first conductivity type of said MOSFET formed in said first channel base region (14a).

6. A semiconductor device according to claim 1 or 2, characterized in that said first channel base region (14a) and second conductivity impurity diffusion region (20) are contiguous to each other.

7. A semiconductor device according to claim 6, characterized in that an insulating layer is formed on said low inpurity concentration epitaxial layer (12) between said channel base region (14a) and impurity diffusion region (20).

8. A semiconductor device according to any one of the preceding claims characterized in that the impurity concentration of said second conductivity type impurity diffusion region (20) constitiuting said bypass diode (D3) is higher than the impurity concentration of said first and second channel base regions (14a, 14b).

9. A semiconductor device according to any one of the preceding claims characterized in that said gate electrode (17, 27) is formed in a V-shaped groove formed in said low impurity concentration epitaxial layer (12, 22).

10. A semiconductor device according to any one of the preceding claims characterized in that a lifetime killer is selectively diffused in said impurity diffusion region (20) constituting said bypass diode (D3) and a surrounding portion of said low impurity concentration epitaxial layer (12).

## Patentansprüche

1. Halbleiteranordnung mit einem einen MOSFET (QM1) tragenden Substrat (11) eines ersten Leitfähigkeitstyps mit einer hohen Störstellenkonzentration, einer auf einer Oberfläche des Halbleitersubstrats (11) gebildeten epitaxischen Schicht (12) mit einer niedrigen Störstellenkonzentration, einer auf der anderen Oberfläche des Halbleitersubstrats (11) gebildeten MOSFET-Drain-Elektrode (13), ersten und zweiten MOSFET-Kanal-Basisbereichen (14a, 14b) eines zweiten Leitfähigkeitstyps, die in einem vorbestimmten Abstand voneinander in der epitaxischen Schicht (12) mit einer niedrigen Störstellenkonzentration gebildet sind, ersten und zweiten MOSFET-Quellenbereichen (15a, 15b) eines ersten Leitfähigkeitstyps mit einer hohen Störstellenkonzentration, die in den ersten bzw. zweiten Kanal-Basisbereichen (14a, 14b) gebildet sind, einem MOSFET-Gate-Oxidfilm (16), der auf der epitaxischen Schicht (12) mit einer niedrigen Störstellenkonzentration zwischen den ersten und zweiten Kanal-Basisbereichen (14a, 14b) derart gebildet ist, daß er einen Teil der Oberfläche des Kanal-Basis-und Quellenbereiches abdeckt, einer an dem Gate-Oxidfilm (16) gebildeten MOSFET-Gate-Elektrode (17), einem auf der Gate-Elektrode (17) gebildeten Isolierfilm (18), einer auf den Isolierfilm (18), den Kanal-Basis-Bereichen (14a, 14b) und den Quellenbereichen (15a, 15b) gebildeten MOSFET-Quellenelektrode (19), einer durch die ersten und zweiten Kanal-Basisbereiche (14a, 14b) und die epitaxische Schicht (12) mit einer niedrigen Störstellenkonzentration gebildeten parasitären Diode (D1) und einem Übergang, der aus einer Diode (D3) besteht, die zu der parasitären Diode (D1) elektrisch parallel ist, und der einen Durchlaßspannungsabfall, niedriger als der der parasitären Diode (D1) aufweist, dadurch gekennzeichnet daß eine Störstellendiffusionsbereich (20) des zweiten Leitfähigkeitstyps in der epitaxischen Schicht (12) mit einer niedrigen Störstellenkonzentration gelbildet ist, um die Diode (D3) elektrisch parallel zu der parasitären Diode (D1) zu bilden, wobei die Quellenelektrode (19) auf dem die Diode bildenden Störstellendiffusionsbereich (20) des zweiten Leitfähigkeitstyps gebildet ist, und

die Überbrückungsdiode (D3) einen Durchlaßspannungsabfall aufweist, der niedriger als der der parasitären Diode (D1) ist, wobei Durchlaßstrom, der sonst durch die parasitäre Diode (D1) fließt, beim Einsatz durch die Überbrückungsdiode (D3) derart verzweigt ist, daß die in der epitaxischen Schicht (12) mit einer niedrigeren Störstellenkonzentration gespeicherten Träger zu einer Stelle geleitet werden, um einen parasitären bipolaren Transistor (QB1) am Betrieb zu hindern und die Durchschlagspannung des MOSFETS (QM1) zu erhöhen.

2. Halbleiteranordnung nach Anpruch 1, gekennzeichnet durch Sperrschichten (10a, 10b), die in Kontaktbereichen zwischen den ersten und zweiten Kanal-Basisbereichen (14a, 14b) und ersten und zweiten Quellenbereichen (15a, 15b) und dem Quellenbereich (19) gebildet sind.

3. Halbleiteranordnung nach Anspruch 1 oder 2, dadurch gekennzeichnet, daß der Diffusionsbereich (20) des zweiten Leitfähigkeitstyps, der die Überbrückungsdiode (D3) bildet, in einem Vorbestimmten Abstand von den ersten und zweiten Kanal-Basisbereichen (14a, 14b) gebildet ist.

4. Halbleiteranordnung nach Anspruch 3, dadurch gekennzeichnet, daß ein Isolierfilm (18) auf der epitaxischen Schicht (12) mit einer niedrigen Störstellenkonzentration zwischen dem Kanal-Basis-Bereich (14a) und Störstellendiffusionsbereich (20) gebildet ist.

5. Halbleiteranordnung nach Anspruch 3 oder 4, gekennzeichnet durch einen Gate-Oxidfilm, der auf der eptiaxischen Schicht (12) mit einer niedrigen Störstellenkonzentration zwischen einem Kanal-Basisbereich (14a) und Störstellendiffusionsbereich (20) gebildet ist, eine Gate-Elektrode, die auf dem Gate-Oxid-Film gebildet ist, einen Isolierfilm, der auf der Gate-Elektrode gebildet ist, und einen Quellenbereich des ersten Leitfähigkeitstyps des MOSFETS mit einer hohen Störstellenkonzentration, der in dem ersten Kanal-Basisbereich (14a) gebildet ist.

6. Halbleiteranordnung nach Anspruch 1 oder 2, dadurch gekennzeichnet, daß der erste Kanal-Basisbereich (14a) und Störstellendiffusionsbereich (12) der zweiten Leitfähigkeit aneinander grenzen.

7. Halbleiteranordnung nach Anspruch 6, dadurch gekennzeichnet, daß eine Isolierschicht auf der epitaxischen Schicht (12) mit einer niedrigen Störstellenkonzentration zwischen dem Kanal-Basisbereich (14a) un dem Störstellendiffusionsbereich (20) gebildet ist.

8. Halbleiteranordnung nach einem der vorhergehenden Ansprüche, dadurch gekennzeichnet, daß die Störstellenkonzentration des die Überbrückungsdiode (D3) bildenden Störstellendiffusionsbereichs (20) des zweiten Leitfähigkeitstyps höher als die Störstellenkonzentration der ersten und zweiten Kanal-Basisbereiche (14a, 14b) ist.

9. Halbleiteranordnung nach einem der vorhergehenden Ansprüche, dadurch gekennzeichnet, daß die Gate-Elektroden (17, 27) in einer V-förmigen Rille gebildete sind, die in der epitaxischen Schicht (12, 22) mit einer niedrigen Störstellenkonzentration gebildet ist.

10. Halblieteranordnung nach einem der vorhergehenden Ansprüche, dadurch gekennzeichnet, daß ein Lebensdauerbegrenzer in den die Überbrückungsdiode bildenden Störstellendiffusionsbereich (20) und einen umgebenden Teil der epitaxischen Schicht mit de niedrigen Störstellenkonzentration selektiv diffundiert ist.

## Revendications

1. Dispositif à semi-conducteur comprenant un substrat semi-conducteur (11) à concentration élevée d'impureté d'un premier type de conductivité portant un transistor MOSFET (QM1), une couche épitaxiale (12) à faible concentration d'impureté formée sur une première surface du substrat semi-conducteur (11), une électrode (13) de drain du transistor MOSFET formée sur l'autre surface du substrat semi-conducteur (11), une première et une second région de base de canal MOSFET (14a, 14b) d'un second type de conductivité formées à une distance prédéterminée l'une de l'autre dans la couche épitaxiale (12) à faible concentration d'impureté, une premère et une second région de source MOSFET à concentration élevée d'impureté (15a, 15b) du premier type de conductivité, formées dans la première et la seconde région respective de base de canal (14a, 14b) un film (16) d'oxyde de grille de transistor MOSFET formé sur la couchs épitaxiale (12) à faible concentration d'impureté entre la première et la seconde région de base de canal (14a, 14b) de manière qu'il recouvre une partie de la surface des régions de base de canal et de source, une électrode (17) de grille MOSFET formée sur le film (16) d'oxyde de grille, un film isolant (18) formé sur l'électrode (17) de grille, une électrode (19) de source de transistor MOSFET formée sur le film isolant (18), sur les regions de base de canal (14a, 14b) et sur les régions de source (15a, 15b), une diode parasite (D1) formée par la première et la seconde région de base de canal (14a, 14b) et la couche épitaxiale (12) à faible concentration d'impureté, en une jonction constituant une diode (D3) montée électriquement en parallèle avec la diode parasite (D1) et ayant une chute de tension dans le sens direct inférieure à celle de la diode parasite (D1), caractérisé par une région de diffusion d'impureté (20) du second type de conductivité, formée sur la couche épitaxiale (12) à faible concentration d'impurete afin qu'elle constitue la diode (D3) montée électriquement en parallèle avec la diode parasite (D1), l'électrode (19) de source étant formée sur la région de diffusion d'impureté (20) du second type de conductivité constituant la diode, et par le fait qui la diode en dérivation (D3) a une chute de tension dans le sens direct qui est inférieure à celle de la diode parasite (D1) si bien que le courant dans le sens direct circulant autrement dans la diode parasite (D1) est dérivé pendant le fonctionnement dans la diode en dérivation (D3), et que les porteurs stockés dans la couche épitaxiale (12) à faible concentration d'impureté sont conduits à un emplacement tel qu'un transistor bipolaire parasite (QB1) ne peut pas fonctionner et que la tension de claquage du transistor MOSFET (QM1) augmente.

2. Dispositif à semi-conducteur selon la revendication 1, caractérisé par des couches barrières (10a, 10b) formées dans des zones de contact entre les première et seconde régions de base de canal (14a, 14b) de la première et de la seconde région de source (15a, 15b) et de la région de source (19).

3. Dispositif à semi-conducteur selon l'une des revendications 1 et 2, caractérisé en ce que la région de diffusion d'impureté (20) du second type de conductivité constituant la diode en dérivation (D3) est formée à une distance prédéterminée de la première et de la second région de base de canal (14a, 14b).

4. Dispositif à semi-conducteur selon la revendication 3, caractérisé en ce que le film isolant (18) est formé sur la couche épitaxiale (12) à faible concentration d'impureté entre la région de base de canal (14a) et la région de diffusion d'impureté (20).

5. Dispositif à semi-conducteur selon l'une des revendications 3 et 4, caractérisé par un film d'oxyde de grille formé sur la couche épitaxiale (12) de faible concentration d'impureté entre une région de base de canal (14a) et une région de diffusion d'impureté (20), une électrode de grille formée sur le film d'oxyde de grille, un film isolant formé sur l'électrode de grille, et une région de source à concentration élevée d'impureté du premier type de conductivité du transistor MOSFET formée dans la première région de base de canal (14a).

6. Dispositif à semi-conducteur selon l'une des revendications 1 et 2, caractérisé en ce que la première région de base de canal (14a) et la région de diffusion d'impureté (20) du second type de conductivité sont contiguës.

7. Dispositif à semi-conducteur selon la revendication 6, caractérisé en ce qu'une couche isolante est formée sur la couche épitaxiale (12) à faible concentration d'impureté entre la région de base de canal (14a) et la région de diffusion d'impureté (20).

8. Dispositif à semi-conducteur selon l'une quelconque des revendications précédentes, caractérisé en ce que la concentration d'impureté de la région de diffusion d'impureté (20) du second type de conductivité constituant la diode de dérivation (D3) est supérieure à la concentration d'impureté de la première et de la seconde région de base de canal (14a, 14b).

9. Dispositif à semi-conducteur selon l'une quelconque des revendications précédentes, caractérisé en ce que l'électrode de grille (17, 27) est formée dans une gorge en V réalisée dans la couche épitaxiale (12, 22) à faible concentration d'impureté.

10. Dispositif à semi-conducteur selon l'une quelconque des revendications précédentes, caractérisé en ce qu'un réducteur de durée de vie a diffusé sélectivement dans la région de diffusion d'impureté (20) constituant la diode de dérivation (D3) et dans une partie environnante de la couche épitaxiale (12) à faible concentration d'impureté.

# F I G. 1

# F I G. 2

# F I G. 3

# F I G. 4

FIG. 5

FIG. 6

0 133 642

3

FIG. 7

19 18

10b

10a

N+

P

N+

15b

14b

P

N−

N+

16 17

15a

14a

N+

20

P

N+

12

11

13

FIG. 8

19 18

N+

P

N+

15b

14b

N−

P

16 17

15a

14a

P

20

N+

12

11

13

FIG. 9

P

14a   15a   16   17   15b   14b

20

N⁻   12

N⁺   11

13

FIG. 10

19   18

P

14a   15a   16   17   15b   14b

20

N⁻   12

N⁺   11

13

FIG. 11

28   26   27

N⁺   N⁺   N⁺   N⁺

P         P              P              P

29   30a   25a   24   25b   30b

22

N⁻

N⁺   21

23